# EUROPÄISCHE PATENTANMELDUNG

(11) **EP 1 593 976 A2**
(43) Veröffentlichungstag der Anmeldung: **09.11.2005**
(21) Anmeldenummer: 05009530.6
(22) Anmeldetag: 30.04.2005
(51) Int. Cl.: G01R 11/04

(54) **Zählerschrank zur Aufnahme wenigstens eines Stromzählers**

(30) Priorität: 08.05.2004 DE 102004022785
(71) Anmelder: ABB PATENT GmbH, 68526 Ladenburg (DE)
(72) Erfinder: Roth, Michael, 77886 Lauf (DE); Schaaf, Harry, Dipl.-Ing., 77836 Rheinmünster (DE)
(74) Vertreter: Miller, Toivo

(57) **Zusammenfassung**

Die Erfindung betrifft einen Zählerschrank (10) mit einem Zählerplatz (11, 40) zur Aufnahme wenigstens eines Haushaltszählers, an dessen Unterseite Kontaktfahnen und Haltekrallen angeordnet sind, wobei die Kontaktfahnen mit im Zählerplatz (11, 40) angeordneten Kontaktstücken in elektrisch leitende Verbindung bringbar sind und die Haltekrallen in montierten Zustand des Zählers hinter je eine Hinterschneidung greifen. Die Kontaktstücke sind in einem Gehäuse (17) untergebracht, das in eine Aussparung (41) an der Abdeckplatte des Zählers eingesetzt ist.

## Beschreibung

Die Erfindung betrifft einen Zählerschrank gemäß den Oberbegriff des Anspruches 1.

An einem Zählerplatz in einem Zählerschrank befindet sich normalerweise ein Zählerkreuz, auf dem ein elektrischer Stromzähler befestigbar ist.

Im Zuge der weiteren Entwicklung wird angestrebt, einen elektronischen Haushaltszähler einzusetzen, an dessen Unterseite Kontaktfahnen und Haltekrallen angeordnet sind, wobei die Kontaktfahnen mit im Zählerplatz des Zählerschrankes angeordneten Kontaktstücken in elektrisch leitende Verbindung gebracht werden können. Die Haltekrallen hintergreifen in montiertem Zustand des Zählers jeweils eine Hinterschneidung.

Ein Zähler, der so ausgebildet ist, ist in der DE 101 04 170 beschrieben. Zwar ist dort davon die Rede, dass der Zähler an einer Plattform festgelegt werden kann; wie die Plattform im Zählerschrank untergebracht ist, ist nicht dargestellt.

Aufgabe der Erfindung ist es daher, einen Zählerschrank der eingangs genannten Art zu schaffen, der einen Zählerplatz enthält, in den ein elektronischer Haushaltszähler gemäß der DE 101 04 170 eingesetzt werden kann.

Diese Aufgabe wird erfindungsgemäß gelöst durch die Merkmale des Anspruches 1.

Erfindungsgemäß sind die Kontaktstücke sowie die Hinterschneidungen in einem Gehäuse untergebracht, dass in eine Aussparung einer Abdeckplatte des Zählerplatzes eingesetzt ist.

In besonders vorteilhafter Ausgestaltung der Erfindung kann das mit Schlitzen zur Aufnahme der Kontaktfahnen versehene Gehäuse beidseitig zu dem Bereich, in dem sich die Schlitze befinden (Schlitzbereich) senkrecht zur Verbindungslinie zweier zueinander gehörender Schlitze mit je eine Stufung versehen sein, so dass das Gehäuse im Schlitzbereich eine vergrößerte Höhe aufweist. Die Aussparung ist dabei der Umfangskontur des Schlitzbereiches angepasst, so dass das Gehäuse mit dem Schlitzbereich von hinten in die Aussparung einsetzbar ist. Ein besonderer Vorteil besteht darin, dass die Anordnung so getroffen werden kann, dass die vordere Fläche des Schlitzbereiches etwa in der Ebene der vorderen Fläche der Abdeckplatte liegt.

Dabei bestehen zwei Möglichkeiten:
Die Zu- und Abgangsleitungen zu dem Zähler können auf einer Seite des Gehäuses, die senkrecht zu der Verbindungslinie liegt, in das Gehäuse eingeführt sein; bei einer anderen Ausgestaltung, die als vorteilhaft angesehen wird, können die Zugangsleitungen auf einer Seite des Gehäuses ein- und die Abgangsleiter auf der anderen Seite des Gehäuses herausgeführt sein.

Weitere vorteilhafte Ausgestaltungen der Erfindung sind den weiteren Ansprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen und weitere Vorteile näher erläutert und beschrieben werden.

Es zeigen
- Fig. 1: ein Gehäuse, an dem der Stromzähler festlegbar ist, in perspektivischer Darstellung,
- Fig. 2: einen Teil des Zählerschrankes im Bereich des Zählerplatzes vor Montage des Gehäuses und
- Fig. 3: den Zählerschrank gemäß Fig. 2 im Endzustand.

Es sei nun Bezug genommen auf die Fig. 3.
Dort ist ein Teilausschnitt eines Zählerschrankes 10 im Bereich des Zählerplatzes 11 gezeigt, an dem zwei nebeneinanderliegende Schlitzbereiche 12, 13 vorgesehen sind.

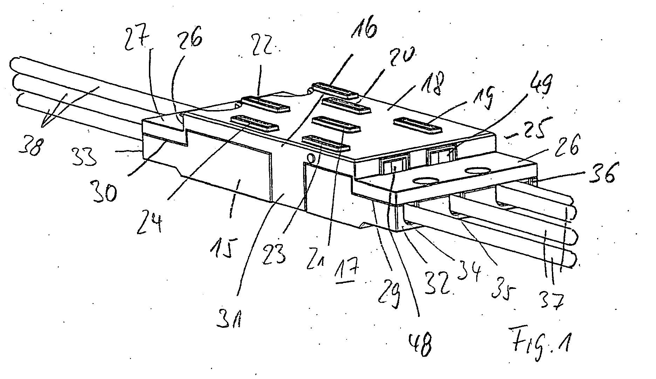

Die Fig. 1 zeigt ein Gehäuse, das in den Zählerschrank 10 eingebaut werden kann und an dem ein Zähler festlegbar ist.

Das Gehäuse besitzt ein Gehäuseunterteil 15 sowie ein Gehäuseoberteil 16, die miteinander in nicht näher dargestellter Weise durch Verrastung und/oder Verschraubung verbunden sind. Innerhalb des Gehäuses, das in seiner Gesamtheit mit 17 bezeichnet ist, befinden sich Kontaktstücke, die mit Kontaktfahnen am Zähler in elektrisch leitende Verbindung gelangen können; der Aufbau und die Anordnung der Kontaktstücke ist der DE 101 04 170 zu entnehmen. Insoweit ist der Inhalt dieser Patentanmeldung hier von Bedeutung.

Das Gehäuse 17 besitzt drei Abschnitte. In einem mittleren Abschnitt 18 (auch Schlitzbereich 18 genannt), befinden sich Schlitze 19, 20, 21, 22, 23 und 24, durch die Kontaktfahnen am Zähler eingesteckt werden können. Schlitze, in die die Haltekrallen eingreifen, sind in der Ausführung gemäß Fig. 1 nicht zu sehen, vielmehr in der Ausführung gemäß Fig. 3.

Der Schlitzbereich 18 ist senkrecht zur Verbindungslinie zweier zugehöriger Schlitze durch eine Stufe 25 bzw. 26 begrenzt, über die der Schlitzabschnitt 18 oder Schlitzbereich 18 in je einen Anschlussklemmenabschnitt 27 und 28 übergeht. Zu diesem Zweck besitzt auch das Gehäuseunterteil je eine Stufung 29, 30; ebenso sind am Gehäuseoberteil 16 Stufungen (ohne Bezugsziffern) vorgesehen, die den Stufungen 29, 30 entsprechen, so dass das Gehäuseoberteil 16 passend auf das Gehäuseunterteil 15 aufgesetzt werden kann. Am Gehäuseoberteil 16 ist eine Art Rastarm 31 auf den Seiten angeformt, die parallel zu der Verbindungslinie zugehöriger Schlitze verlaufen, so dass das Gehäuseoberteil mit den Armen 31 am Gehäuseunterteil fixiert ist. Selbstverständlich können auch andere Arten der Verbindung zwischen Gehäuseunterteil 15 und Gehäuseoberteil 16 vorgesehen sein.

An den beiden entgegengesetzt liegenden Schmalseitenwänden 32, 33, die senkrecht zur Verbindungslinie zweier zugehöriger Schlitze verlaufen, sind Einführöffnungen 34, 35 und 36 vorgesehen, durch die Zugangsleiter 37 ins Innere des Gehäuses 17 eingeführt werden. Unterhalb des Abschnittes 26 bzw. 27 befinden sich Anschlussklemmen zur Verbindung mit den entsprechenden Kontaktstücken.

Aus der entgegengesetzt zur Schmalseitenwand 32 verlaufenden Schmalseitenwand 33 sind Abgangsleiter 38 herausgeführt, an denen Verbrauchernetze anschließen.

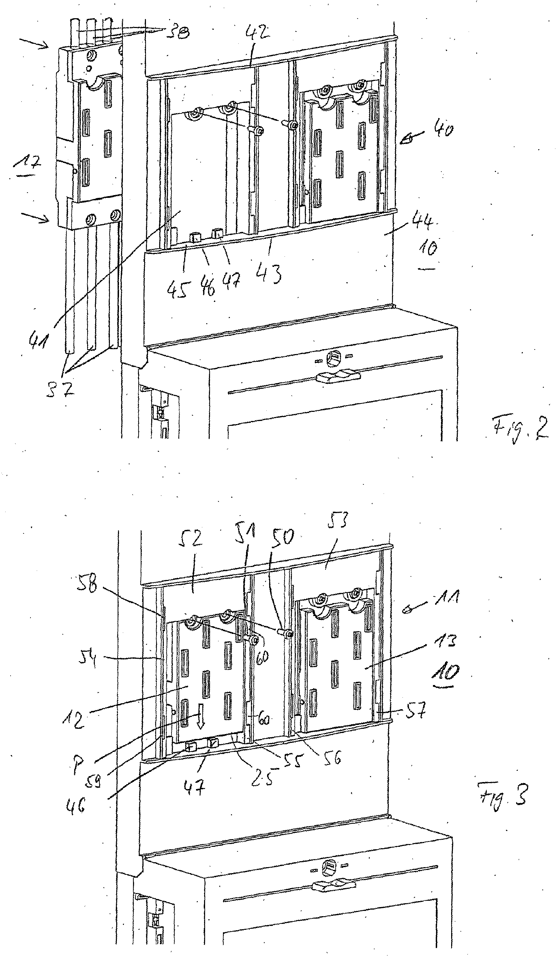

Im Zählerschrank 10, siehe Fig. 2, befindet sich ein Zählerplatz 40, an dem, wie aus Fig. 3 hervorgeht, zwei Stromzähler angebracht werden können. Der Zählerplatz 40 besitzt zwei Aussparungen, von denen lediglich die in Fig. 2 links befindliche Aussparung mit der Bezugsziffer 41 bezeichnet ist. Oberhalb und unterhalb des Zählerplatzes sind Begrenzungsleisten 42, 43 vorgesehen, die senkrecht zu der Oberfläche 44 vorspringen. An der zur Aussparung 41 hinweisenden Innenfläche 45 der unteren Leiste 43 sind zwei Haken 46, 47 in Form von Vorsprüngen angeformt. An der Stufung 25 des Gehäuseoberteils 18 sind Rücksprünge 48 und 49 vorgesehen, in die bei der Montage die Vorsprünge 46 und 47 eingreifen.

Die Fig. 2 zeigt das Gehäuse 17 mit den Zugangs- und Abgangsleitungen 37, 38 schwebend hinter dem Zählerplatz 40. In Fig. 3 ist dargestellt, dass sich das Gehäuse 17 in einer Vormontagestellung oberhalb der Vorsprünge 46, 47 befindet. Durch Absenken gemäß Pfeilrichtung P legt sich die Stufung 25 auf die untere Leiste 43, wie in der Fig. 3 an dem Schlitzabschnitt 13 ersichtlich ist, und die Rücksprünge 48, 49 (oder Vertiefungen) übergreifen die Vorsprünge 46, 47. Mittels zweier Befestigungsschrauben 50, 51 wird das Gehäuse 17 an einer die Aussparungen nach oben hin begrenzenden Abdeckung 52 bzw. 53 befestigt. Damit ist auf einfache Weise das Gehäuse 15, auf den der Zähler aufgesetzt werden kann, innerhalb des Zählerplatzes bzw. des Zählerschrankes 10 fixiert.

Die Aussparungen für die Gehäuse bzw. für die Schlitzabschnitte 12, 13 besitzen an ihren in montierter Richtung vertikal verlaufenden Seitenkanten Leisten 54, 55, 56, 57, in denen sich Schlitze 58, 59; 60, 61 befinden, die parallel zur Verbindungslinie der Schlitze zur Aufnahme der Kontaktfahnen verlaufen; in diese Schlitze, die als Halteschlitze bezeichnet sind, greifen dann die Haltekrallen am Zähler ein.

Die Befestigung des Zählers kann so erfolgen, dass der Zähler auf den jeweiligen Schlitzbereich 12 bzw. 13 senkrecht aufgesetzt und quer dazu verschoben wird, was entweder manuell oder gegebenenfalls auch mittels eines Werkzeuges erfolgen kann. Dabei wäre im Bereich der Abdeckung 52 bzw. 53 eine oder mehrere Zugangsöffnungen zum Einsetzen eines Werkzeuges vorgesehen, sowie in der DE 101 04 170 beschrieben.

## Patentansprüche

1. Zählerschrank (10) mit einem Zählerplatz (11, 40) zur Aufnahme wenigstens eines Haushaltszählers, an dessen Unterseite Kontaktfahnen und Haltekrallen angeordnet sind, wobei die Kontaktfahnen mit im Zählerplatz (11, 40) angeordneten Kontaktstücken in elektrisch leitende Verbindung bringbar sind und die Haltekrallen in montierten Zustand des Zählers hinter je eine Hinterschneidung greifen, **dadurch gekennzeichnet, dass** die Kontaktstücke in einem Gehäuse (17) untergebracht sind, das in eine Aussparung (41) an der Abdeckplatte des Zählers eingesetzt ist.

2. Zählerschrank nach Anspruch 1, **dadurch gekennzeichnet, dass** das mit Schlitzen (19, 20, 21, 22, 23, 24) für die Kontaktfahnen versehene Gehäuse (17) beidseitig zu dem Bereich, in dem sich die Schlitze (19, 20, 21, 22, 23, 24) befinden, senkrecht zur Verbindungslinie zweier zueinander gehörender Schlitze (19, 20, 21, 22, 23, 24) je eine Stufung (29, 30) aufweist, so dass das Gehäuse (17) im Schlitzbereich (12, 13) eine vergrößerte Höhe aufweist, und dass die Aussparung (41) der Umfangskontur des Schlitzbereiches (12, 13) angepasst sind, so dass das Gehäuse (17) mit dem Schlitzbereich (12, 13) von hinten in die Aussparung (41) einsetzbar ist, dergestalt, dass die vordere Fläche des Schlitzbereiches (12, 13) etwa in der Ebene der vorderen Fläche der Abdeckplatte am Zählerplatz (11, 40) liegt.

3. Zählerschrank nach Anspruch 1 oder 2, **dadurch gekennzeichnet, dass** die Zu- und Abgangsleitungen auf einer Seite, die senkrecht zu der Verbindungslinie liegt, in das Gehäuse (17) eingeführt sind.

4. Zählerschrank (10) nach einem der Ansprüche 1 oder 2, **dadurch gekennzeichnet, dass** die Zugangsleitungen auf einer Seite des Gehäuses (17), die senkrecht zu der Verbindungslinie zweier zugehöriger Schlitze (19, 20, 21, 22, 23, 24) liegt, und die Abgangsleitungen zu den Verbrauchern auf der entgegengesetzten Seite ein- bzw. herausgeführt sind.

5. Zählerschrank (10) nach einem der vorherigen Ansprüche, **dadurch gekennzeichnet, dass** an der unten liegenden, horizontal verlaufenden Wandung der Aussparung (41) Vorsprünge (46, 47) vorgesehen sind, die in montiertem Zustand in Rücksprünge im Gehäuse (17) greifen, und dass im Bereich der horizontal verlaufenden oberen Kante der Aussparung (41) Befestigungselemente in Form von Schrauben vorgesehen sind.

6. Zählerschrank (10) nach einem der vorherigen Ansprüche, **dadurch gekennzeichnet, dass** die Aussparungen (41) an ihren vertikal verlaufenden Kanten Leisten (54, 55, 56, 57) aufweisen, in denen Halteschlitze (58, 59, 60, 61) zur Aufnahme der Haltekrallen des Zählers vorgesehen sind.

7. Zählerschrank (10) nach einem der vorherigen Ansprüche, **dadurch gekennzeichnet, dass** zwei Aussparungen für zwei Gehäuse und damit zwei Zähler vorgesehen sind.
